# EUROPÄISCHE PATENTANMELDUNG

(11) **EP 1 094 322 A1**
(43) Veröffentlichungstag der Anmeldung: **25.04.2001**
(21) Anmeldenummer: 99121034.5
(22) Anmeldetag: 21.10.1999
(51) Int. Cl.: G01R 29/08, H01Q 1/24

(54) **Messvorrichtung zur Messung der Intensität von schwacher elektromagnetischer Strahlung, Plasmafeldern, Ionenfeldern, Photonenfelder und/oder Elektrosmog**

(71) Anmelder: Kehlbeck, Heinrich, D-27318 Hoya (DE)
(72) Erfinder: Kehlbeck, Heinrich, D-27318 Hoya (DE)
(74) Vertreter: Cohausz & Florack

(57) **Zusammenfassung**

Die Erfindung betrifft eine Meßvorrichtung zur Messung der Intensität von schwacher elektromagnetischer Strahlung, insbesondere im Mikrowellenbereich, von Plasmafeldern, Ionenfeldern, Photonenfeldern und/oder von Elektrosmog. Um mit einfachen Mitteln eine hochempfindliche, verläßliche und leicht zu handhabende Meßvorrichtung zur Verfügung zu stellen, mit der die Intensität einer solchen Strahlung meßbar ist, ist vorgesehen, daß die Meßvorrichtung eine auf den Frequenzbereich der zu erfassenden Größe ausgelegte Resonanzantenne (1) aufweist, zwischen deren Anschlußenden eine Gleichrichterschaltung (2,3) geschaltet ist, geeignet zum Gleichrichten von in die Resonanzantenne induzierten Wechselströmen sowie zum Laden einer mit dem Ausgang der Gleichrichterschaltung (2,3) verbundenen Kapazität, die mit einem Meßinstrument (5) zum Erfassen und Anzeigen der an der Kapazität anliegenden Spannung verbunden ist.

## Beschreibung

Die Erfindung betrifft eine Meßvorrichtung zur Messung der Intensität von schwacher elektromagnetischer Strahlung, insbesondere im Mikrowellenbereich, sowie von Plasmafeldern, Ionenfeldern, Photonenfeldern und/oder Elektrosmog.

Bemühungen zur Erfassung von schwacher elektromagnetischer Strahlung, insbesondere im Mikrowellenbereich, sowie von Plasmafeldern, Ionenfeldern, Photonenfeldern und/oder von Elektrosmog sind aus der Praxis bekannt. Bislang stehen jedoch keine physikalischen Meßvorrichtungen zur Verfügung, mit denen auch die jeweilige Intensität dieser Größen einfach und zuverlässig bestimmt werden kann.

Der Erfindung liegt die Aufgabe zugrunde, mit einfachen Mitteln eine hochempfindliche, verläßliche und leicht zu handhabende Meßvorrichtung zur Verfügung zu stellen, mit der die Intensität von schwacher elektromagnetischer Strahlung, insbesondere im Mikrowellenbereich, sowie von Plasmafeldern, Ionenfeldern, Photonenfeldern und/oder von Elektrosmog meßbar ist.

Die Aufgabe wird erfindungsgemäß mit einer Meßvorrichtung gelöst, die eine auf den Frequenzbereich der zu erfassenden Größe ausgelegte Resonanzantenne aufweist, zwischen deren Anschlußenden eine Gleichrichterschaltung geschaltet ist, geeignet zum Gleichrichten von in die Resonanzantenne induzierten Wechselströmen sowie zum Laden einer mit dem Ausgang der Gleichrichterschaltung verbundenen Kapazität, die mit einem Meßinstrument zum Erfassen und Anzeigen der an der Kapazität anliegenden Spannung verbunden ist.

Die erfindungsgemäße Meßvorrichtung geht von der Erkenntnis aus, daß die zu messenden, hochfrequenten Größen in entsprechend ausgelegten Resonanzantennen einen hochfrequenten Wechselstrom induzieren, dessen Wert von der jeweiligen Intensität der zu messenden Größe abhängig ist. Die Resonanzantenne resoniert dabei je nach Frequenzbereichsabmessung mit einer bestimmten Mikrowellenfrequenz, z.B. mit 2,45 Gigahertz. Der in die Resonanzantenne induzierte Wechselstrom wird über eine geeignete Gleichrichterschaltung gleichgerichtet und dann dazu verwendet, eine mit der Gleichrichterschaltung verbundene Kapazität in eine bestimmte Richtung zu laden. Dabei ist der maximal erreichte Spannungswert über der Kapazität an einem Meßort von der Größe des induzierten Wechselstroms und damit ebenfalls von der jeweiligen Intensität der zu messenden Größe abhängig. Die über der Kapazität anliegende Gleichspannung wird nun mit dem Meßinstrument erfaßt und der Spannungswert als ein die Intensität der zu erfassenden Größe abbildender Wert ausgegeben.

Der Vorteil der erfindungsgemäßen Meßvorrichtung besteht darin, daß sie hochempfindlich und verläßlich ist, so daß auch sehr schwache Größen eindeutig erfaßt werden können. Hinzu kommt, daß die Meßvorrichtung einen einfachen Aufbau aufweist und ihre Handhabung sehr anwenderfreundlich ist.

Nach einer vorteilhaften Ausgestaltung der erfindungsgemäßen Meßvorrichtung umfaßt die Gleichrichterschaltung zwei Dioden, wobei die erste Diode an einem Anschlußende der Resonanzantenne mit Durchlaßrichtung zur Resonanzantenne hin angeschlossen ist, und die zweite Diode an dem anderen Anschlußende der Resonanzantenne mit Durchlaßrichtung von der Resonanzantenne weg angeschlossen ist, und wobei der Kondensator zwischen die zwei von der Resonanzantenne abgewandten Enden der ersten und der zweiten Diode geschaltet ist.

Damit die Erfassung der Strahlung besonders genau und mit gutem Wirkungsgrad erfolgen kann, sollten die eingesetzten Dioden eine für den zu messenden Frequenzbereich verlustarme Gleichrichterfunktion besitzen sowie eine extrem niedrige Diodendurchlaßspannung aufweisen. Solche niedrigen Durchlaßspannungen sind beispielsweise bei einzelnen, ausgesuchten Schottky-Dioden oder Tunneldioden anzutreffen.

Vorteilhafterweise wird als Kapazität die durch die Verbindungsleitungen zu dem Meßinstrument gebildete Kapazität eingesetzt, wodurch auf den Einsatz eines zusätzlichen Kondensators verzichtet werden kann. Für solche als Kapazität genutzte Verbindungsleitungen eignen sich vor allem kurze und dünne Koaxialkabel.

In einer weiteren bevorzugten Ausgestaltung der erfindungsgemäßen Meßvorrichtung wird die Resonanzantenne aus einem Rohr gefertigt, das so geknickt wird, daß es eine ebene Fläche begrenzt. Wird dieses Rohr an den Knickpunkten und an den Endstellen, die als Antennenanschlußpunkte verwendet werden, gequetscht, so können eine optimale Nutzung des Skineffektes durch eine große Antennenoberfläche und gute Resonanzeingenschaften erzielt werden.

Die Dioden werden in diesem Fall vorteilhafterweise in der Mitte der gequetschten Antennenschlußpunkten angeschlossen, wobei die Dioden zu diesem Zweck nicht gelötet werden sollten, da die Erwärmung beim Löten die besonderen Eigenschaften der Dioden mindert.

Soll für die erfindungsgemäße Meßvorrichtung statt einer einzigen Antenne ein Antennenarray eingesetzt werden, so kann dieses insbesondere aus einer Parallelschaltung von zwei Dipolantennen bestehen.

Weitere vorteilhafte Ausgestaltungen der erfindungsgemäßen Meßvorrichtung gehen aus den Unteransprüchen hervor.

Der Einsatz der erfindungsgemäßen Meßvorrichtung ist vor allem in der Bestimmung von Elektrosmog im Umfeld von Maschinen und elektronischen Gräten sowie in der Bestimmung von Plasma- und Ionenfeldern zu sehen. Die Meßvorrichtung ist aber ebenso geeignet, die Abstrahlungen der geopathogenen Zonen in verschiedenen Tiefen korrekt anzuzeigen. Da bei klarem Wetter jedoch auch die Energie der Sonne in Minivolt angezeigt wird, empfiehlt es sich, die Abstrahlungen von geopathogenen Zonen bei bedecktem Himmel zu messen. Schließlich ist es auch möglich, sich mittels der erfindungsgemäßen Meßvorrichtung die Aurastrahlung von Pflanzen quantitativ anzeigen zu lassen.

Die Erfindung wird nun anhand eines Ausführungsbeispiels unter Bezugnahme auf eine Zeichnung näher erläutert.

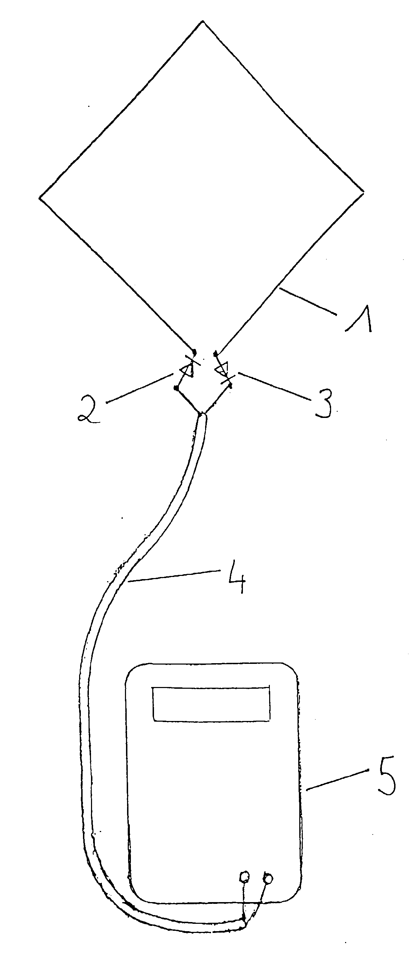

Die einzigen Figur zeigt eine erfindungsgemäße Meßvorrichtung zum Erfassen der Intensität von schwacher elektromagnetischer Strahlung, insbesondere im Mikrowellenbereich, von Plasmafeldern, Ionenfeldern, Photonenfeldern und/oder von Elektrosmog.

Die Meßanordnung weist zunächst eine Resonanzantenne 1 auf. Die Resonanzantenne 1 ist aus einem Rohr gefertigt, das an drei Stellen so geknickt ist, daß es eine ebene, quadratische Fläche begrenzt, die an einer Ecke des Quadrats offen ist, wobei die Enden des Rohrs an dieser Stelle die Antennenanschlußpunkte bilden. An den einzelnen Knickstellen des Rohrs sowie an dessen offenen Enden ist das Rohr gequetscht, um eine Oberflächenverkleinerung zu vermeiden. Die Abstände der benachbarten Knickstellen des Rohres zueinander sowie zu den Enden des Rohrs sind so gewählt, daß sie genau einem Bruchteil von λ der gewünschten Resonanzfrequenz entsprechen, also λ/4, λ/8 usw.

An den offenen Enden ist die Resonanzantenne 1 jeweils mit einer Diode 2,3 verbunden, wobei die Dioden 2,3 so angeschlossen sind, daß die Durchlaßrichtung der ersten Diode 2 zu der Resonanzantenne 1 hin und die Durchlaßrichtung der zweiten Diode 3 von der Resonanzantenne 1 weg zeigt. Als Dioden 2,3 werden hier Schottky-Dioden des Typs BAT 45 00,3 A / 15 V, die eine sehr niedrige Diodendurchlaßspannung aufweisen, eingesetzt.

Die von der Resonanzantenne 1 abgewandten Enden der Dioden 2,3 sind über ein dünnes Koaxialkabel 4 mit einem Meßinstrument 5 verbunden. Das Koaxialkabel 4 weist eine Länge von 46 cm und eine Kapazität von 46 pF auf.

Das Meßinstrument 5 ist ein Mikrovoltmeter und hat mit 10 Megaohm einen hohen Eingangswiderstand, der über einen mit der entsprechenden Beschaltung versehenen, an den Eingang gelegten Feldeffekttransistor zur Verfügung gestellt wird.

Die Meßvorrichtung arbeitet wie folgt:

An einem gegebenen Meßort soll die Intensität einer dort vermuteten schwachen elektromagnetischen Strahlung bestimmt werden. Zu diesem Zweck wird nun die erfindungsgemäße Meßvorrichtung an den zu untersuchenden Ort gebracht. Die Resonanzantenne 1 der Meßvorrichtung ist dabei auf den Frequenzbereich der zu erfassenden Strahlung, z.B. auf 2,45 Gigahertz, ausgelegt.

Sobald sich die Resonanzantenne 1 in einer Ausrichtung in dem Strahlungsfeld befindet, bei der die Normale der von der Resonanzantenne 1 definierten Fläche nicht senkrechte zu den Feldlinien verläuft, wird in der Resonanzantenne 1 ein hochfrequenter Wechselstrom induziert.

Die mit der Resonanzantenne 1 verbundenen Dioden 2,3 üben bezüglich des in der Resonanzantenne 1 induzierten Wechselstroms eine Gleichrichterfunktion aus. Die durch das Koaxialkabel 4 gebildete Kapazität wird mit dem aus dem Wechselstrom erzeugten Gleichstrom in der durch die Durchlaßrichtung der Dioden vorgegebenen Richtung aufgeladen. Die aufgrund der geringen Intensität von Strahlungsfeldern sehr kleine über der Kapazität abfallende Spannung wird über den in dem Meßinstrument integrierten Feldeffekttransistor verstärkt und als Digitalwert angezeigt.

Die Größe der angezeigten Spannung ist zum einen abhängig von der Intensität der untersuchten Strahlung und zum anderen von der Ausrichtung der Resonanzantenne 1 zum Strahlungsfeld. Damit die an verschiedenen Stellen erfaßten Intensitätswerte vergleichbar sind, muß darauf geachtet werden, daß die durch die Resonanzantenne 1 abgegrenzten Fläche stets im gleichen Winkel zu den Feldlinien ausgerichtet ist. Sinnvollerweise wird deshalb angestrebt, daß die Feldlinien bei jeder Messung senkrecht zu der durch die Resonanzantenne 1 abgegrenzten Fläche verlaufen. Eine solche Ausrichtung ist nämlich mittels der Anzeige des Meßinstruments leicht einzustellen, da sie genau dann gegeben ist, wenn an der Stelle, an der die Intensität bestimmt werden soll, die Resonanzantenne 1 so ausgerichtet ist, daß der maximale, an dieser Stelle erfaßbare Spannungswert auf dem Anzeigefeld des Meßinstruments angezeigt wird. Bei einem vertikal verlaufenden Strahlungsfeld wird sich so eine horizontale Ausrichtung der durch die Resonanzantenne 1 gebildete Fläche ergeben.

## Patentansprüche

1. Meßvorrichtung zur Messung der Intensität von schwacher elektromagnetischer Strahlung, insbesondere im Mikrowellenbereich, von Plasmafeldern, Ionenfeldern, Photonenfeldern und/oder von Elektrosmog, die eine auf den Frequenzbereich der zu erfassenden Größe ausgelegte Resonanzantenne (1) aufweist, zwischen deren Anschlußenden eine Gleichrichterschaltung (2,3) geschaltet ist, geeignet zum Gleichrichten von in die Resonanzantenne induzierten Wechselströmen sowie zum Laden einer mit dem Ausgang der Gleichrichterschaltung (2,3) verbundenen Kapazität, die mit einem Meßinstrument (5) zum Erfassen und Anzeigen der an der Kapazität anliegenden Spannung verbunden ist.

2. Meßvorrichtung nach Anspruch 1,
**dadurch gekennzeichnet,**
daß die Gleichrichterschaltung zwei Dioden umfaßt, wobei die erste Diode (2) an einem Anschlußende der Resonanzantenne (1) mit Durchlaßrichtung zur Resonanzantenne (1) hin angeschlossen ist, und die zweite Diode (3) an dem anderen Anschlußende der Resonanzantenne (1) mit Durchlaßrichtung von der Resonanzantenne (1) weg angeschlossen ist, und wobei der Kondensator zwischen die zwei von der Resonanzantenne (1) abgewandten Enden der ersten und der zweiten Diode (2,3) geschaltet ist.

3. Meßvorrichtung nach einem der voranstehenden Ansprüche,
**dadurch gekennzeichnet,**
daß das Meßinstrument (5) durch einen die Spannung über der Kapazität anzeigenden Mikrovoltmeter oder durch einen Strom durch den bzw. Spannung über der Kapazität festhaltenden Linienschreiber gebildet wird.

4. Meßvorrichtung nach einem der voranstehenden Ansprüche,
**dadurch gekennzeichnet,**
daß die Kapazität durch einen Kondensator gebildet oder durch die Kapazität der Verbindungsleitungen (4), insbesondere eines Koaxialkabels, zu dem Meßinstrument (5) zur Verfügung gestellt wird.

5. Meßvorrichtung nach einem der voranstehenden Ansprüche,
**dadurch gekennzeichnet,**
daß die Dioden (2,3), die insbesondere Schottky-Dioden oder Tunneldioden sind, eine besonders niedrige Durchlaßspannung aufweisen.

6. Meßvorrichtung nach einem der voranstehenden Ansprüche,
**dadurch gekennzeichnet,**
daß die durch die Dioden (2,3) zur Verfügung gestellte Gleichrichterfunktion verlustarm für den zu erfassenden Frequenzbereich ist.

7. Meßvorrichtung nach einem der voranstehenden Ansprüche,
**dadurch gekennzeichnet,**
daß die Antenne (1) aus einem Rohr besteht, das so geformt ist, daß es eine im wesentlichen ebene Fläche begrenzt.

8. Meßvorrichtung nach Anspruch 7,
**dadurch gekennzeichnet,**
daß die von dem Rohr begrenzte Fläche im wesentlichen rechteckig, insbesondere im wesentlichen quadratisch, ist.

9. Meßvorrichtung nach Anspruch 8,
**dadurch gekennzeichnet,**
daß die benachbarten Eckpunkte des von dem Rohr gebildeten Rechtecks Abstände voneinander aufweisen, die einem Bruchteil der Wellenlänge λ der gewünschten Resonanzfrequenz, wie λ/4 oder λ/8, entsprechen.

10. Meßvorrichtung nach einem der Ansprüche 7-9,
**dadurch gekennzeichnet,**
daß die Eckstellen des die Antenne (1) bildenden Rohrs und/oder die Enden des Rohrs gequetscht sind.

11. Meßvorrichtung nach einem der voranstehenden Ansprüche,
**dadurch gekennzeichnet,**
daß die Dioden (2,3) in der Mitte der Antennenenden angeschlossen werden.

12. Meßvorrichtung nach einem der voranstehenden Ansprüche,
**dadurch gekennzeichnet,**
daß mehrere Antennen (1) zu einem Antennenarray zusammengeschaltet werden.
